(19) Europäisches Patentamt / European Patent Office / Office européen des brevets

(11) **EP 2 565 936 B1**

(12) **EUROPEAN PATENT SPECIFICATION**

(45) Date of publication and mention of the grant of the patent:
**29.03.2017 Bulletin 2017/13**

(21) Application number: **11774769.1**

(22) Date of filing: **05.04.2011**

(51) Int Cl.:
*C08J 7/06* (2006.01)　　*H01L 31/049* (2014.01)
*H01L 31/042* (2014.01)　*B32B 27/36* (2006.01)
*B32B 27/40* (2006.01)　　*C08J 7/04* (2006.01)
*B32B 27/08* (2006.01)　　*B32B 27/30* (2006.01)
*B32B 27/20* (2006.01)　　*H01L 31/048* (2014.01)

(86) International application number:
**PCT/JP2011/058641**

(87) International publication number:
**WO 2011/135985 (03.11.2011 Gazette 2011/44)**

(54) **LAMINATED POLYESTER FILM AS PROTECTIVE MATERIAL FOR REAR SURFACE OF SOLAR CELL**

BESCHICHTETER POLYESTERFILM ALS SCHUTZMATERIAL FÜR DIE RÜCKSEITENFLÄCHE EINER SOLARZELLE

FILM DE POLYESTER STRATIFIÉ COMME MATÉRIAU PROTECTEUR POUR SURFACE ARRIÈRE DE PHOTOPILE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.10.2010 JP 2010238683**
**29.04.2010 JP 2010104632**

(43) Date of publication of application:
**06.03.2013 Bulletin 2013/10**

(73) Proprietor: **Mitsubishi Plastics, Inc.**
**Tokyo 100-8252 (JP)**

(72) Inventors:
• **MASUDA, Narihiro**
**Maibara-shi**
**Shiga 521-0234 (JP)**
• **NOZAWA, Koutarou**
**Maibara-shi**
**Shiga 521-0234 (JP)**
• **Kiehne, Thorsten**
**Maibara-shi**
**Shiga 521-0234 (JP)**

(74) Representative: **Ter Meer Steinmeister & Partner Patentanwälte mbB**
**Nymphenburger Straße 4**
**80335 München (DE)**

(56) References cited:
EP-A1- 2 040 306　　EP-A1- 2 415 599
EP-A1- 2 479 026　　EP-A1- 2 624 308
WO-A1-2010/094443　JP-A- 2007 204 538
JP-A- 2008 130 642　JP-A- 2008 147 530
JP-A- 2009 212 122　JP-A- 2009 224 761
JP-A- 2010 016 286

**Description**

TECHNICAL FIELD

The present invention relates to a laminated polyester film for a protective material for protecting a back surface of photovoltaic cells, and more particularly, to a laminated polyester film for a protective material for protecting a back surface of photovoltaic cells in which a white film having a high reflectance is used as a base material film, and which is excellent in hydrolysis resistance and can exhibit an excellent water-resistant adhesion property to sealing resins such as ethylene-vinyl acetate copolymer resins (hereinafter occasionally referred to merely as "EVA") and polyvinyl butyral resins (hereinafter occasionally referred to merely as "PVB") which are used as a sealing material for photovoltaic cells.

BACKGROUND ART

In recent years, solar power generation has been considerably noticed as an energy source useful for preventing global warming problems, and have already prevailed to a considerable extent. As a typical example of solar power generation, there may be mentioned photovoltaic cells using a semiconductor such as monocrystalline silicon, polycrystalline silicon and amorphous silicone. The photovoltaic cells have been practiced on the basis of such a principle that when sunlight is applied to a semiconductor, an electric current is generated from the semiconductor. In recent years, photovoltaic cells having a relatively large size have been noticed. The photovoltaic cells are installed in any sunny places exposed to natural outdoor environments including undeveloped areas such as deserts and waste lands and roofs of houses or large buildings. The photovoltaic cells tend to be considerably deteriorated in performance thereof when water reaches a semiconductor cell as a central part thereof. Therefore, the photovoltaic cells are required to have a high strength and a high water resistance as a package capable of withstanding severe natural environments for a long period of time. In addition, when installed on roofs of housings or the like, the photovoltaic cells have been required to have a light weight.

As a typical example of the construction of the photovoltaic modules comprising the above durable package, there are known photovoltaic cells having the following construction. That is, there is known the photovoltaic cell construction in which cells for the photovoltaic cells, i.e., photoelectric semiconductor elements are generally sealed by inserting a sealing resin such as EVA between a glass substrate as a surface-side transparent protective member located on a light receiving side and a protective material film on a rear side thereof. In this construction, EVA serves for fixing the photovoltaic cells.

When using a polyester film as the back surface protective material, adhesion between the polyester film and EVA, etc, tends to be poor, and it is therefore required, for example, to provide an easy-bonding layer or use an adhesive in order to improve an adhesion property therebetween.

In order to improve adhesion between the polyester film and EVA, there has been proposed an easy-bonding polyester film for protecting a back surface of photovoltaic cells in which a resin coating film comprising a crosslinking agent in an amount of 10 to 100% by weight is applied on the polyester film (Patent Document 1).

Meanwhile, there is the premise that the photovoltaic modules are used outdoors for a long period of time (for example, 20 years or longer) and therefore may be exposed to high-temperature and high-humidity environmental conditions. In this case, there tends to occur such a problem that the polyester film as a protective material for photovoltaic cells suffers from hydrolysis at an ester bond moiety in a molecular chain thereof, so that mechanical properties of the polyester film by themselves tend to be deteriorated with time. In addition, there tends to be present another problem that an easy-bonding layer for improving a heat adhesion property to EVA, etc., is also deteriorated under high-temperature and high-humidity environmental conditions with time, so that adhesion to EVA, etc., can be hardly maintained.

On the other hand, light leaked from between photovoltaic cells is incident on a protective material film for protecting a back surface of the photovoltaic cells. It has been required that the protective material for protecting a back surface of the photovoltaic cells utilizes such a leakage light for enhancing a photoelectric conversion efficiency. Conventionally, there is known the technique in which when a polyester film is used as the protective material for protecting a back surface of the photovoltaic cells, a white pigment is added to a polyester in order to impart a reflectance to the polyester.

For example, in Examples of Patent Document 2, it is described that titanium dioxide or barium sulfate is incorporated into a polyester to prepare a white film. The white polyester film can exhibit a suitability as a protective material for protecting a back surface of photovoltaic cells by using a polyester resin having an excellent hydrolysis resistance as the polyester.

However, for example, as a result of evaluating a hydrolysis resistance of an adhesion property of the white polyester film described in Patent Document 2 by applying the resin coating film proposed in Patent Document 1 thereonto, it was confirmed that the resulting film failed to maintain a sufficient adhesion property. That is, it was confirmed that when the white pigment was added to the polyester film until reaching a concentration sufficient to reflect the leakage light, the resulting polyester film was deteriorated in water-resistant adhesion property to EVA, PBV or the like as compared to the case where no white pigment or a less amount of the white pigment is added to the polyester film.

PRIOR ART DOCUMENTS

Patent Documents

Patent Document 1: Japanese Patent Application Laid-Open (KOKAI) No. 2006-152013
Patent Document 2: Japanese Patent Application Laid-Open (KOKAI) No. 2007-204538

SUMMARY OF THE INVENTION

Problems to be Solved by the Invention

The present invention has been accomplished to solve the above problems. An object of the present invention is to provide a laminated polyester film for a protective material for protecting a back surface of photovoltaic cells in which a high-reflectance white film is used as a base material film thereof, and which is excellent in hydrolysis resistance and can exhibit an excellent water-resistant adhesion property to sealing resins such as EVA and PVB used as a sealing material for photovoltaic cells by forming a coating layer thereon.

Means for Solving Problems

As a result of the present inventors' earnest study, it has been found that the above problems can be solved by using a laminated polyester film having a specific structure. The present invention has been attained on the basis of this finding.
That is, in an aspect of the present invention, there is provided a biaxially stretched polyester film for a protective material for protecting a back surface of photovoltaic cells comprising a laminated polyester film produced by co-extrusion, wherein the laminated polyester film comprises the below-mentioned polyester (A) layer as at least one of outermost layers of the laminated polyester film and at least one below-mentioned polyester (B) layer, wherein the laminated polyester film has a terminal carboxyl group content of not more than 26 equivalents/t, and the polyester (A) layer being provided on at least one surface thereof with a coating layer formed of a polyurethane having at least one of a polycarbonate skeleton and a polyether skeleton, and a crosslinking agent:

•  Polyester (A) layer: Layer formed of a polyester comprising an aromatic polyester as a main constitutional component and having a white pigment content of less than 8% by weight; and
•  Polyester (B) layer: Layer formed of a polyester comprising an aromatic polyester as a main constitutional component and having a white pigment content of not less than 8% by weight;

-  a coating layer which is provided on at least one of the at least one outermost polyester (A) layer and is formed of a polyurethane having at least one of a polycarbonate skeleton and a polyether skeleton, and a crosslinking agent;
-  a sealing resin for a photovoltaic cell adhered onto the coating layer.

EFFECT OF THE INVENTION

The film of the present invention provides a laminated polyester film for a protective material for protecting a back surface of photovoltaic cells in which a high-reflectance white film is used as a base material film thereof and which is excellent in hydrolysis resistance as the base material film and can exhibit an excellent water-resistant adhesion property to sealing resins such as EVA and PVB used as a sealing material for photovoltaic cells by providing a coating layer thereon. Therefore, the present invention has a high industrial value.

PREFERRED EMBODIMENTS FOR CARRYING OUT THE INVENTION

The present invention has been accomplished based on such a technical concept that only when a polyester film as a base material has an excellent hydrolysis resistance even under high-temperature and high-humidity conditions and at the same time, a coating layer formed on the polyester film for improving an adhesion property of the film also has a good hydrolysis resistance, the resulting laminated film can provide an easy-bonding film having a good hydrolysis resistance. When any of the polyester film as the base material and the coating layer formed thereon is deteriorated in hydrolysis resistance, the hydrolysis resistance of the resulting easy-bonding film tends to be strongly influenced by the polyester film or the coating layer whichever is more deteriorated in hydrolysis resistance, and therefore tends to become insufficient. For this reason, in order to obtain a polyester film having an excellent hydrolysis resistance as an easy-bonding film, it is inevitably required that the base material film and the coating layer both are excellent in hydrolysis resistance. On the basis of the above technical concept, the present invention is individually explained in detail below with respect to the polyester film as the base material and the coating layer.

The polyester film as a base material according to the present invention is in the form of a laminated polyester film comprising a layer (polyester (A) layer) formed of a polyester comprising an aromatic polyester as a main constitutional component and having a white pigment content of less than 8% by weight as at least one of outermost layers thereof, and further comprising at least one layer (polyester (B) layer) formed of a polyester comprising an aromatic polyester as a main constitutional component and having a white pigment content of not less than 8% by weight. The laminated polyester film is required to have a terminal carboxyl group content of not more than 26 equivalents/t as measured with respect to a whole portion of the film.

The polyester used as the base material for the film according to the present invention means an aromatic polyester obtained by polycondensing an aromatic dicarboxylic acid and an aliphatic glycol. Examples of the aromatic dicarboxylic acid include terephthalic acid, isophthalic acid and 2,6-naphthalenedicarboxylic acid. Examples of the aliphatic glycol include ethylene glycol, diethylene glycol and 1,4-cyclohexanedimethanol. Among these polyesters, preferred is polyethylene terephthalate (PET) from the viewpoint of a good balance between costs and performance. Thus, in the present invention, a polyethylene terephthalate film may be suitably used as the polyester film.

The polyester raw materials for the polyester film used as the base material in the present invention may comprise compounds of metals such as antimony, titanium and germanium which are frequently used usually upon polymerization for production of polyesters as a polymerization catalyst. However, when the amount of the polymerization catalyst used is excessively large, the polyester tends to suffer from decomposition reaction when melted to form a film therefrom, which tends to result in high terminal carboxylic acid concentration owing to reduction in molecular weight, etc., and deteriorated hydrolysis resistance of the resulting film. On the other hand, when the amount of the polymerization catalyst used is excessively small, the polymerization reaction rate tends to be lowered, so that the polymerization time tends to be prolonged and the terminal carboxylic acid concentration of the obtained polyester tends to be increased, which tends to result in deteriorated hydrolysis resistance of the resulting film. For the above reasons, in the present invention, the amount of antimony used is usually in the range of 50 to 400 ppm and preferably 100 to 350 ppm; the amount of titanium used is usually in the range of 1 to 20 ppm and preferably 2 to 15 ppm; and the amount of germanium used is usually in the range of 3 to 50 ppm and preferably 5 to 40 ppm. These polymerization catalysts may be used alone or in combination of any two or more thereof.

It is required that the polyester film used as a base material according to the present invention is in the form of a laminated polyester film comprising a layer (polyester A layer) formed of a polyester comprising an aromatic polyester as a main constitutional component and having a white pigment content of less than 8% by weight as at least one of outermost layers thereof, and further comprising at least one layer (polyester B layer) formed of a polyester comprising an aromatic polyester as a main constitutional component and having a white pigment content of not less than 8% by weight.

Examples of the above white pigment include titanium dioxide, zinc oxide, zinc sulfide and barium sulfate. Among these white pigments, preferred are titanium dioxide and barium sulfate, and especially preferred is titanium dioxide of an anatase crystal type from the viewpoint of a high shielding property and a high light resistance.

The average particle diameter of the white pigment is usually in the range of 0.1 to 1.0 $\mu$m and preferably 0.2 to 0.5 $\mu$m. When the average particle diameter of the white pigment is less than 0.1 $\mu$m or more than 1.0 $\mu$m, the resulting film tends to be decreased in optical density (OD), so that it may be difficult to effectively enhance a light reflecting performance of the polyester film to such an extent as corresponding to an amount of the white pigment added.

The polyester (A) layer constituting at least one of outermost layers of the film of the present invention is required to have a white pigment content of less than 8% by weight. The white pigment content of the polyester (A) layer is preferably not more than 5% by weight and more preferably not more than 3% by weight. The lower limit of the white pigment content of the polyester (A) layer is 0% by weight, that is, the polyester (A) layer may comprise no white pigment. When the white pigment content of the polyester (A) layer is not less than 8% by weight, the polyester (A) layer tends to be deteriorated in water-resistant adhesion property against the below-mentioned coating layer formed on the polyester A layer and the sealing resin such as EVA and PVB.

Also, the at least one polyester (B) layer provided in the polyester film for a protective material for protecting a back surface of photovoltaic cells according to the present invention is required to have a white pigment content of not less than 8% by weight. The white pigment content of the polyester (B) layer is preferably not less than 10% by weight and more preferably not less than 15% by weight. The upper limit of the white pigment content of the polyester (B) layer is not particularly limited, and may be set to about 30% by weight at which the polyester (B) layer tends to be deteriorated in mechanical strength. When the white pigment content of the polyester (B) layer is less than 8% by weight, the polyester film as a whole tends to be deteriorated in optical density (OD), so that the resulting polyester film for a protective material for protecting a back surface of photovoltaic cells tends to be insufficient in light reflecting performance.

The polyester film of the present invention may be compounded with particles in addition to the above white pigment for the purpose of mainly imparting an easy-slipping property to the film. The particles to be compounded in the film are not particularly limited, and any particles can be used as long as they are capable of imparting an easy-slipping property to the film. Specific examples of the particles include particles of silica, calcium carbonate, magnesium carbonate, barium carbonate, calcium sulfate, silicon oxide, kaolin, aluminum oxide and the like. In addition, there may also be used refractory organic particles as described in Japanese Patent Publication (KOKOKU) No. 59-5216, Japanese Patent Application Laid-Open (KOKAI) No. 59-217755, etc. Examples of the other refractory organic particles include particles of heat-cured urea resins, heat-cured phenol resins, heat-cured epoxy resins, benzoguanamine resins or the like. Further, there may also be used deposited particles produced by precipitating or finely dispersing a part of the metal compounds such as the catalyst during the step for production of the polyester.

The particles used for imparting an easy-slipping property to the film preferably have an average particle diameter of usually 0.1 to 10 $\mu$m. The amount of the particles added may be selected from the range of 0.005 to 5.0% by weight.

The method of adding the white pigment or the easy-slipping property-imparting particles to the polyester film is not particularly limited, and any conventionally known methods may be suitably used in the present invention. For example, the particles may be added in any optional stage of the production process of a polyester as the raw material. The particles are preferably added in the esterification stage or after completion of the transesterification reaction to allow the polycondensation reaction to proceed. In addition, there may also be used the method of kneading a slurry prepared by dispersing the particles in ethylene glycol or water with the polyester raw material using a vented twin-screw extruder, a method of kneading the dried particles with the polyester raw material, and the like. In particular, in the case where the polyester film comprises the white pigment, there is preferably used the method in which the white pigment is added to the polyester raw material to prepare a high-concentration master batch, and the master batch is diluted upon use when forming the film therefrom from the viewpoint of reducing a terminal carboxylic acid content in the polyester constituting the film.

Meanwhile, in the polyester film of the present invention, in addition to the above particles, various conventionally known additives such as an antioxidant, a thermal stabilizer, a lubricant, an antistatic agent, a fluorescent brightener, a dye and a pigment may be added thereto, if required. Also, for the purpose of enhancing a light resistance, an ultraviolet absorber may be added to the polyester film in an amount of 0.01 to 5 parts by weight based on the weight of the polyester. Examples of the ultraviolet absorber include triazine-based compounds, benzophenone-based compounds and benzoxazinone-based compounds. Among these ultraviolet absorbers, the benzoxazinone-based compounds are especially preferably used. Also, in the case where the film itself has a laminated structure having three or more layers, there may also be suitably used the method in which these ultraviolet absorbers are added to an intermediate layer. As a matter of course, these ultraviolet absorbers or additives may be prepared in the form of a high-concentration master batch, and may be diluted upon use when forming the film.

It is required that the film of the present invention comprises the above polyester (A) layer as at least one of outermost layers thereof, and further comprises the above polyester (B) layer. In this case, the simplest laminated layer structure of the film is a layer structure of (A) layer/(B) layer. Examples of the other laminated layer structures may include a layer structure of (A) layer/(B) layer/(A) layer and a layer structure of (A) layer/intermediate layer/(A) layer in which the (B) layer is present in the intermediate layer, as well as a layer structure of (A) layer/(B) layer/(C) layer in which the other (C) layer constitutes another outermost layer, and a layer structure of (A) layer/intermediate layer/(C) layer in which the (B) layer is present in the intermediate layer. By constructing the above laminated layer structures, it is confirmed that when forming a coating layer on one surface of the below-mentioned (A) layer, the polyester film exhibits a good water-resistant adhesion property to the coating layer formed thereon as compared to the case where the coating layer is formed on the (B) layer (for example, in the case of providing the (B) layer singly, or in the case of forming both the outermost layers from the polyester (B) layer to which a large amount of the white pigment is added, such as a layer structure of (B) layer/(A) layer/(B) layer). Although the reason therefor is not clearly determined, it is suggested that the polyester film comprising a large amount of the white pigment undergoes accelerated hydrolysis under high-temperature and high-humidity conditions in close vicinity of an interface region between the polyester film and the coating layer owing to influence of the white pigment to a more or less extent. On the other hand, in the case where the coating layer is present on the polyester film comprising a less amount of the white pigment, it is suggested that the film hardly undergoes hydrolysis in close vicinity of the interface region between the polyester film and the coating layer, so that adhesion between the polyester film and the coating layer can be maintained.

The ratio of a thickness of the polyester (A) layer to a thickness of the polyester (B) layer is not particularly limited, and the minimum thickness of these layers is preferably not less than 0.5 $\mu$m and more preferably not less than

1 $\mu$m because separation between the layers hardly occurs.

As the laminating method of the polyester film according to the present invention, it is adopted a so-called co-extrusion method using two melting extruders, or three or more melting extruders. The thickness of the polyester film is not particularly limited as long as it lies within the range capable of maintaining a film shape, and is usually in the range of 20 to 500 $\mu$m and preferably 25 to 300 $\mu$m.

In the film according to the present invention, it is required that the terminal carboxylic acid content in the film is not more than 26 equivalents/t as measured with respect to a whole portion of the film (except for the coating layer and the white pigment) by the below-mentioned method, and the terminal carboxylic acid content is preferably not more than 24 equivalents/t. When the terminal carboxylic acid content in the film is more than 26 equivalents/t, the polyester film tends to be deteriorated in hydrolysis resistance. The hydrolysis resistance of the polyester film is a property associated with the whole portion of the film. In the present invention, it is required that the terminal carboxylic acid content in the polyester constituting the film as a whole lies within the above-specified range. On the other hand, in view of the hydrolysis resistance as required in the present invention, the lower limit of the terminal carboxylic acid content in the polyester is nor particularly limited, and is usually about 10 equivalents/t from the viewpoints of attaining a high polycondensation reaction efficiency and preventing hydrolysis or thermal decomposition of the polyester upon melt-extrusion step, etc.

In the present invention, the terminal carboxylic acid content in the polyester film may be adjusted to the specific range by the following methods. That is, in the melt-extrusion step of polyester chips during the process for production of the film, there may be used a) the method of possibly avoiding occurrence of hydrolysis of the polyester chips owing to water contained therein, b) the method of possibly shortening a retention time of the polyester in an extruder or a melt line, or the like.

As a specific example of the method a), there may be used a method of previously drying the raw material to a sufficient extent such that the water content therein is preferably controlled to not more than 50 ppm and more preferably not more than 30 ppm in the case of using a single-screw extruder, a method of providing a vent port on a twin-screw extruder to maintain an inside of the extruder at a reduced pressure of not more than 40 hPa, preferably not more than 30 hPa and more preferably not more than 20 hPa, etc.

As a specific example of the method b), there is preferably used the method in which a retention time of the polyester from charging of the raw material into an extruder to initiation of discharging a molten sheet from a die is preferably adjusted to 20 min or shorter and more preferably 15 min or shorter.

Also, it is important that the film formation process is conducted using a polyester having a low terminal carboxylic acid content as a raw material to obtain a polyester film whose terminal carboxylic acid content lies within the specific range. More specifically, the terminal carboxylic acid content of the raw polyester material is preferably not more than 20 equivalents/t and more preferably not more than 15 equivalents/t as a total amount thereof. As the method of reducing the terminal carboxylic acid content in the polyester chips, there may be adopted any conventionally known methods such as the method of increasing a polymerization efficiency, the method of increasing a polymerization rate, the method of suppressing a decomposition rate, the method of using combination of melt-polymerization and solid state polymerization, etc. These methods may be realized, for example, by the method of shortening a polymerization time, the method of increasing an amount of a polymerization catalyst, the method of using a high-activity polymerization catalyst, the method of reducing a polymerization temperature, etc. In the case of using combination of the melt polymerization and the solid state polymerization, the polyester obtained after the melt polymerization is formed into chips and then subjected to solid state polymerization under reduced pressure while heating or in an inert gas flow such as nitrogen in a temperature range of 180 to 240°C. The resulting polyester preferably has an intrinsic viscosity of not less than 0.55 dl/g and more preferably 0.60 to 0/90 dl/g. Also, upon production of the film, when using a regenerated raw material obtained through the melting step, the terminal carboxylic acid content of the resulting film tends to be increased. Therefore, in the present invention, it is preferred that none of such a regenerated raw material be compounded, or even when compounded, the amount of the regenerated raw material compounded is preferably not more than 20 parts by weight.

The phosphorus element content in the polyester film as the base material used in the present invention is preferably in the range of 0 to 170 ppm and more preferably 0 to 140 ppm as measured with respect to a whole portion of the film and detected in analysis using the below-mentioned fluorescent X-ray analyzer. The phosphorus element content in the polyester film may be 0 ppm. The phosphorus element is usually derived from phosphoric acid compounds added as a catalyst component upon production of the polyester. In the present invention, when the phosphorus element content satisfies the above specific range, it is possible to impart a good hydrolysis resistance to the film. When the phosphorus element content is excessively large, the film tends to suffer from accelerated hydrolysis owing to the phosphoric acid compounds. The hydrolysis resistance of the polyester film is a property associated with a whole portion of the film. Therefore, in the present invention, it is preferred that the phosphorus content of the polyester constituting the film as a whole lie within the above-specified range.

Examples of the phosphoric acid compound include known compounds such as phosphoric acid, phosphorous acid or esters thereof, phosphonic acid compounds, phosphinic acid compounds, phosphonous acid compounds, and phosphinous acid compounds. Specific examples of the phosphoric acid compound include orthophosphoric acid, monomethyl phosphate, dimethyl phosphate, trimethyl phosphate, monoethyl phosphate, diethyl phosphate, triethyl phosphate, ethyl acid phosphate, monopropyl phosphate, dipropyl phosphate, tripropyl phosphate, monobutyl phosphate, dibutyl phosphate, tributyl phosphate, monoamyl phosphate, diamyl phosphate, triamyl phosphate, monohexyl phosphate, dihexyl phosphate and trihexyl phosphate.

In the followings, the process for producing the polyester film according to the present invention is more specifically described. However, the present invention is not particularly limited to the following embodiments as long as the subject matter of the present invention is satisfied.

According to the laminated layer construction of the polyester film, the necessary number of melt extruders are used together with feed blocks or multilayer multi-manifold dies for laminating raw materials from the melt extruders. The polyester chips dried by known methods are fed to a single-screw extruder or the undried polyester chips are fed to a twin-screw extruder, and heated and melted at a temperature not lower than a melting point of the respective polymers. In this case, in order to remove foreign matters from the polyester chips, there may be used the method of passing the polyester chips through known suitable filters or the method of reducing pulsation of a molten polymer using a gear pump. Next, the molten polymers are laminated together and extruded from the respective dices on a rotary cooling drum. The thus extruded sheet is rapidly cooled and solidified on the rotary cooling drum such that the temperature of the sheet is decreased to not higher than a glass transition temperature thereof, thereby obtaining a substantially amorphous unoriented sheet. In this case, in order to enhance a flatness or surface smoothness of the sheet, it is preferred to enhance adhesion between the sheet and the rotary cooling drum. For this purpose, in the present invention, an electrostatic adhesion method and/or a liquid coating adhesion method are preferably used.

In the present invention, the thus obtained sheet is subjected to biaxial stretching to form a film. The stretching conditions are described more specifically. The above-obtained unstretched sheet is preferably stretched at a temperature of 70 to 145°C and a stretch ratio of 2 to 6 times in a longitudinal direction (MD direction) thereof to obtain a longitudinally monoaxially stretched film. Then, the thus obtained monoaxially stretched film is stretched at a temperature of 90 to 160°C and a stretch ratio of 2 to 6 times in a lateral direction (TD direction) thereof. The resulting stretched sheet is then heat-treated at a temperature of 160 to 240°C for a period of 1 s to 600 s. Alternatively, using a simultaneous biaxial stretching machine, the sheet is stretched in longitudinal and lateral directions thereof at the same time at a temperature of 70 to 160°C within the range of an area ratio of 5 to 20 times, and then subjected to the heat treatment under the same conditions as described above. Further, upon the heat treatment, in the heat-treating maximum temperature zone and/or a cooling zone located at an outlet of the heat-treating zone, the resulting film is preferably subjected to relaxation by 0.1 to 20% in longitudinal and/or lateral directions thereof. In addition, the resulting film may be subjected to longitudinal stretching and lateral stretching again, if required.

In the case where the below-mentioned coating layer is applied by an in-line coating method, at the time at which the longitudinal stretching is completed, the coating treatment is carried out, and after the resulting coating layer is dried, the polyester film is subjected to lateral stretching.

Next, the coating layer provided on the film of the present invention is described.

As described above, the polyester film for a protective material for protecting a back surface of photovoltaic cells according to the present invention has the layer formed of a polyester comprising an aromatic polyester as a main constitutional component and having a white pigment content of less than 8% by weight (polyester (A) layer) as at least one of outermost layers thereof. In the present invention, it is required that the polyester film is provided on at least one of the at least one outermost polyester (A) layer with a coating layer comprising a polyurethane having at least one of a polycarbonate skeleton and a polyether skeleton and a crosslinking agent.

In this regard, the above laminated layer structure is more specifically described by adding the coating layer thereto as follows. That is, as the laminated layer structure of the polyester film including the coating layer, there may be mentioned a layer structure of coating layer/(A) layer/(B) layer(/coating layer), a layer structure of coating layer/(A) layer/(B) layer/(A) layer(/coating layer), a layer structure of coating layer/(A) layer/intermediate layer/(A) layer(/coating layer) in which the (B) layer is present in the intermediate layer, a layer structure of coating layer/(A) layer/(B) layer/(C) layer(/coating layer), and a layer structure of coating layer/(A) layer/intermediate layer/(C) layer(/coating layer) in which the (B) layer is present in the intermediate layer. In the above layer structures, "(/coating layer)" means that the coating layer may be present as an optional layer.

In the present invention, as described above, it has been found that when providing the coating layer on the surface of the polyester (A) layer to which a less amount of the white pigment is added, the resulting film is more excellent in hydrolysis-resistant adhesion property as compared to the case where the coating layer is directly provided on the polyester (B) layer to which a large amount of the white pigment is added. Thus, the present invention is based on the technical concept that by imparting a hydrolysis resistance to the coating layer provided for improving an adhesion property of the film, the resulting easy-bonding film can also exhibit a good hydrolysis resistance.

It is required that the coating layer used in the film of the present invention comprises a polyurethane having at least one of a polycarbonate skeleton and a polyether skeleton and a crosslinking agent in order to impart an adhesion property less deteriorated owing to hydrolysis between various sealing resins for photovoltaic cells such as EVA, PBV, ethylene-methyl acrylate copolymers (EMA), ethylene-ethyl acrylate copolymers (EEA) and ethylene-$\alpha$-olefin copolymers, and the polyester film.

The polyurethane having a polycarbonate skeleton or a polyether skeleton may be produced by using a compound having a polycarbonate skeleton or a polyether skeleton as a polyol. Meanwhile, the polyurethane may comprise both of a polycarbonate skeleton and a polyether skeleton at the same time.

The polycarbonate polyol used for production of the polyurethane constituting the coating layer may be obtained, for example, by reacting diphenyl carbonate, dialkyl carbonate, ethylene carbonate or phosgene with a diol, etc. Examples of the diol include ethylene glycol, 1,2-propylene glycol, 1,3-propylene glycol, 1,2-butanediol, 1,3-butanediol, 1,4-butanediol, 1,5-pentanediol, 1,6-hexanediol, 1,4-cyclohexanediol, 1,4-cyclohexane dimethanol, 1,7-heptanediol, 1,8-octanediol, 1,9-nonanediol, 1,10-decanediol, neopentyl glycol, 3-methyl-1,5-pentanediol and 3,3-dimethylol heptane. Among these compounds, the polycarbonate polyols produced using 1,6-hexanediol are preferred from the viewpoints of a good industrial availability, an enhanced adhesion property and a good hydrolysis resistance.

The polycarbonate polyols have a number-average molecular weight of 300 to 5000 in terms of polystyrene as measured by gel permeation chromatography (GPC).

Examples of the polyether polyol used for production of the polyurethane constituting the coating layer include polyoxyethylene polyols (such as polyethylene glycol), polyoxypropylene polyols (such as polypropylene glycol), polyoxytetramethylene polyols (such as polytetramethylene ether glycol), and copolymerized polyether polyols (such as block copolymers or random copolymers of polyoxyethylene glycol and polyoxypropylene glycol, etc.). Among these polyether polyols, polytetramethylene glycol is preferred from the viewpoint of an enhanced adhesion property and a good hydrolysis resistance.

The polyether polyols have a number-average molecular weight of 300 to 5000 in terms of polyethylene glycol as measured by gel permeation chromatography (GPC).

The polyurethane produced by using the above polycarbonate polyols or polyether polyols are more excellent in hydrolysis resistance than those polyurethanes produced using polyester polyols as another generally used polyol.

These polycarbonate polyols or polyether polyols may be respectively used alone or in combination of any two or more thereof. The polycarbonate polyols and the polyether polyols may also be used in combination with each other as described above.

As a polyisocyanate used for production of the polyurethane constituting the coating layer, there may be used conventionally known aliphatic, alicyclic or aromatic polyisocyanates, etc.

Specific examples of the aliphatic polyisocyanates include tetramethylene diisocyanate, dodecamethylene diisocyanate, hexamethylene diisocyanate, 2,2,4-trimethylhexamethylene diisocyanate, 2,4,4-trimethylhexamethylene diisocyanate, 2-methyl pentane-1,5-diisocyanate, and 3-methyl pentane-1,5-diisocyanate.

Specific examples of the alicyclic polyisocyanates include isophorone diisocyanate, hydrogenated xylylene diisocyanate, hydrogenated diphenylmethane-4,4'-diisocyanate, hydrogenated biphenyl-4,4'-diisocyanate, 1,4-cyclohexane diisocyanate, hydrogenated tolylene diisocyanate, 1,3-bis(isocyanatomethyl)cyclohexane, and 1,4-bis(isocyanatomethyl)cyclohexane.

Specific examples of the aromatic polyisocyanates include tolylene diisocyanate, 2,2'-diphenylmethane diisocyanate, 2,4'-diphenylmethane diisocyanate, 4,4'-diphenylmethane diisocyanate, 4,4'-diphenyldimethylmethane diisocyanate, 4,4'-dibenzyl diisocyanate, 1,5-naphthylene diisocyanate, xylylene diisocyanate, 1,3-phenylene diisocyanate, and 1,4-phenylene diisocyanate.

Also, these polyisocyanates may be used alone or in the form of a mixture of any two or more thereof.

Examples of the chain extender include ethylene glycol, propylene glycol, butanediol, diethylene glycol, neopentyl glycol, trimethylol propane, hydrazine, ethylenediamine, diethylenetriamine, isophorone diamine, 4,4'-diaminodiphenylmethane, 4,4'-diaminodicyclohexylmethane and water.

The polyurethane having at least one of a polycarbonate structure or a polyether structure which is used in the coating layer in the present invention may be used in the form of a dispersion or solution prepared using an organic solvent as a medium therefor. However, the polyurethane is preferably used in the form of a dispersion or solution prepared using water as the medium. As the polyurethane in the form of a dispersion or solution in water, there may be used a forced emulsification-type polyurethane prepared using an emulsifier, a self-emulsifiable type or a water-soluble type polyurethane prepared by introducing a hydrophilic group into a polyurethane resin, or the like. In particular, the self-emulsifiable type polyurethane prepared by introducing an ionic group into a skeleton of the polyurethane resin for forming an ionomer thereof is preferably used because it is excellent in liquid storage stability of a coating solution and in water resistance, transparency and adhesion property of the resulting coating layer.

In addition, examples of an anionic group as the ionic group to be introduced into the skeleton of the polyurethane resin include a carboxylate group, a sulfonate group, a phosphate group and a phosphonate group. Examples of a cationic group as the ionic group include a quaternary ammonium group, etc. Specific examples of the carboxylate group as the anionic group include ammonium salts or lower amine salts of dimethylol propionic acid, dimethylol butanoic acid, bis-(2-hydroxyethyl)propionic acid, bis-(2-hydroxyethyl)butanoic acid, trimellitic acid-bis(ethylene glycol) ester, etc. As the quaternary ammonium group as the cationic group, there may be suitably used quaternarized products of N-alkyl dialkanol amines such as N-methyl diethanol amine and N-ethyl diethanol amine, etc. Among these ionic groups, especially preferred are carboxylate groups whose counter ion is an organic amine having a boiling point of not higher than 150°C such as ammonia and triethyl amine, from the viewpoints of a high reactivity with the below-mentioned oxazoline-based crosslinking agent or carbodiimide-based crosslinking agent and an enhanced crosslinking density of the resulting coating layer.

As the method of introducing the ionic group into the urethane resin, there may be used various methods which may be conducted at the respective stages of the polymerization reaction. For example, there may be used the method in which a resin having an ionic group is used as a comonomer component upon synthesis of a prepolymer, the method in which a component having an ionic group is used as one of components such as a polyol, a chain extender and the like.

In the coating layer provided in the film of the present invention, it is required that a crosslinking agent is used in combination with the above polyurethane for the purpose of imparting a heat resistance, a heat-resistant adhesion property, a moisture resistance and an antiblocking property to the resulting coating layer. The crosslinking agent is preferably either water-soluble or water-dispersible. More specifically, it is preferred that the coating layer comprises at least one compound selected from the group consisting of methylolated or alkoxymethylolated melamine-based compounds, benzoguanamine-based compounds, urea-based compounds, acrylamide-based compounds, epoxy-based compounds, isocyanate-based compounds, carbodiimide-based compounds, oxazoline-based compounds, silane coupling agent-based compounds and titanium coupling agent-based compounds. Among these crosslinking agents, especially preferred are oxazoline-based compounds and carbodiimide-based compounds because they are polymer-types cross-linking agents as the are and therefore capable of considerably enhancing a heat-resistant and moisture-resistant adhesion property of the coating layer. Examples of such an oxazoline-based crosslinking agent include industrially available products such as "EPOCROSS (registered trademark)" (tradename) produced by Nippon Shokubai Co., Ltd. Examples of such a carbodiimide-based crosslinking agent include industrially available products such as "CARBODILITE (registered trademark)" (tradename) produced by Nisshinbo Chemical Inc. The crosslinking agent may be added in such an amount that the weight ratio of the crosslinking agent to the polyurethane in the coating layer is 10/90 to 90/10 and preferably 20/80 to 80/20.

In the coating layer provided in the film of the present invention, the total amount of the above-mentioned polyurethane and crosslinking agent components is preferably not less than 50% by weight and more preferably not less than 75% by weight. In addition to these resin components, the other additional resins may be further added to the coating layer. Examples of the other additional resins added to the coating layer include polyester-based resins, acryl-based resins, polyvinyl-based resins and polyester polyurethane resins. However, the polyester-based resins and the polyester polyurethane resins tend to be deteriorated in hydrolysis resistance. Therefore, none of these resins are added to the coating layer, or if added, the amount of these resins added is preferably controlled to less than 10% by weight.

Further, in the present invention, in order to prevent occurrence of blocking in the coating layer and imparting a slip property to the coating layer, it is possible to add fine particles to the coating layer. Examples of the fine particles include inorganic particles such as particles of silica, alumina and metal oxides, and organic particles such as crosslinked polymer particles. The particle size of the fine particles is not more than 150 nm and preferably not more than 100 nm, and the amount of the fine particles added to the coating layer is preferably in the range of 0.5 to 10% by weight.

In addition to the above components, the coating layer may also comprise the other components, if required. Examples of the other components include surfactants, defoaming agents, coatability improvers, thickening agents, antioxidants, antistatic agents, ultraviolet absorbers, foaming agents, dyes and pigments. These additives may be used alone or in combination of any two or more thereof.

As described above, the coating layer provided in the film of the present invention may be formed by applying a coating solution prepared using water as a main medium onto a polyester film. The polyester film to which the coating solution is to be applied may be previously biaxially stretched. However, there is preferably used a so-called in-line coating method in which the polyester film is preferably stretched in at least one direction after applying the coating solution thereto, and then heat-set. According to the in-line coating method, the polyester film and the coating layer can be heat-set at an elevated temperature usually as high as not lower than 200°C at the same time, so that the heat crosslinking reaction of the coating layer is allowed to proceed sufficiently, and the adhesion between the coating layer and the polyester film can be enhanced.

In addition, the coating solution may comprise, in addition to water, one or more organic solvents having a compatibility withy water in an amount of usually not more than 20% by weight for the purposes of enhancing a dispersibility and a storage stability thereof as well as improving a coatability thereof and properties of the resulting coating layer.

As the method of applying the coating solution onto the polyester film as the base material, there may be used optional conventionally known coating methods. Specific examples of the coating methods include a roll coating method, a gravure coating method, a micro-gravure coating method, a reverse coating method, a bar coating method, a roll brush coating method, a spray coating method, an air knife coating method, an impregnation coating method, a curtain coating method and a die coating method. These coating methods may be used alone or in combination of any two or more thereof.

The coating amount of the coating layer as a dried film finally obtained after drying and solidification or after subjected to biaxial stretching and heat-setting, etc., is preferably in the range of 0.005 to 1.0 g/m² and more preferably 0.01 to 0.5 g/m². When the coating amount is less than 0.005 g/m², the resulting coating layer tends to be insufficient in adhesion property. When the coating amount is more than 1.0 g/m², the effect of enhancing the adhesion property of the coating layer is already saturated, and on the contrary, the resulting film rather tends to suffer from drawbacks such as blocking.

In the present invention, the coating layer may be provided on only one surface of the polyester film or may be provided on both surfaces thereof. In addition, the above coating layer comprising a polyurethane having at least one of a polycarbonate skeleton and a polyether skeleton and a crosslinking agent may be provided on one surface of the polyester film, and another coating layer may be provided on the opposite surface of the polyester film.

Examples of the other coating layer provided on the opposite surface of the polyester film include an antistatic coating layer, an easy-bonding coating layer exhibiting an easy-bonding property to a vapor-deposited layer formed of metals or metal oxides, and an easy-bonding coating layer exhibiting an easy-bonding property to an adhesive layer when applying known adhesives thereonto. In this case, the other coating layer may also be formed not on the surface of the polyester (B) layer to which a large amount of the white pigment is added, but on the surface of the polyester (A) layer to which a less amount of the white pigment is added, so that the resulting film can exhibit an excellent hydrolysis-resistant adhesion property. More specifically, as the laminated layer structure of the polyester film, there may be mentioned a layer structure of (coating layer of the present invention)/(A) layer/(B) layer/(A) layer/(the other coating layer), a layer structure of (coating layer of the present invention)/(A) layer/intermediate layer/(A) layer/(the other coating layer) in which the (B) layer is present in the intermediate layer, or the like. Thus, with these layer structures comprising the (A) layer on both surfaces of the film, the resulting polyester film can suitably exhibit an excellent hydrolysis-resistant adhesion property.

EXAMPLES

The present invention is described in more detail below by the following Examples and Comparative Examples.

Meanwhile, the methods for measuring and evaluating various properties of the film are as follows.

(1) Terminal carboxylic acid content (equivalent/t):

The terminal carboxylic acid content was measured by a so-called titration method. More specifically, a phenol red indicator was added to a solution prepared by dissolving the polyester in benzyl alcohol, and the resulting solution was titrated with a water/methanol/benzyl alcohol solution of sodium hydroxide. When the film was provided with a coating layer, in order to eliminate adverse influence of the coating layer on the measurement, the coating layer was washed out and removed using an abrasive-containing cleanser. Thereafter, the thus treated film was sufficiently rinsed with ion-exchanged water, dried, and then subjected to the same measurement as described above. In addition, in the case where the polyester film comprised a white pigment such as titanium dioxide and barium sulfate, the white pigment as a benzyl alcohol-insoluble component was removed from the polyester film by a centrifugal precipitation method, and the pigment-free material was subjected to titration to determine a terminal carboxylic acid content (equivalent/t) based on the polyester component.

(2) Quantitative determination of elements derived from catalyst:

Using a fluorescent X-ray analyzer "Model No.: XRF-1500" manufactured by Shimadzu Corp., the amounts of respective elements in the film were determined under the following conditions as shown in Table 1. In the case where the film to be measured was in the form of a laminated film, the laminated film was melted and then molded into a disk shape, and the disk-shaped molded product was subjected to the measurement of contents of the elements based on the whole portion of the film. Further, in the case where the film was provided with a coating layer, in order to eliminate adverse influence of the coating layer on the measurement, the coating layer was washed out and removed using an abrasive-containing cleanser. Thereafter, the thus treated film was sufficiently rinsed with ion-exchanged water, dried, and then subjected to the same measurement as described above. Meanwhile, in the above method, the detection limit was usually about 1 ppm.

Table 1

|  | Sb | Ge | Ti | P | Ba |
|---|---|---|---|---|---|
| X-ray tube target | Rh4.0kW | Rh4.0kW | Rh4.0kW | Rh4.0kW | Rh4.0kW |

(continued)

|  | Sb | Ge | Ti | P | Ba |
|---|---|---|---|---|---|
| Voltage (kV) | 40 | 40 | 40 | 40 | 40 |
| Current (mA) | 95 | 95 | 95 | 95 | 95 |
| Analyzing crystal | LiF | LiF | LiF | Ge | LiF |
| Detector | FPC | SC | SC | FPC | SC |
| 2θ (deg) | 117.34 | 36.33 | 86.14 | 141.03 | 87.17 |
| Measuring time (sec) two-point background; 20 sec for each | 40.0 | 40.0 | 40.0 | 40.0 | 40.0 |

(3) Intrinsic viscosity:

One gram of a sample to be measured was accurately weighed, and dissolved in a mixed solvent comprising phenol and tetrachloroethane at mixing ratio

(phenol/tetrachloroethane) of 50/50 (parts by weight) to prepare a solution having a concentration (c) of 0.01 $g/cm^3$. The relative viscosity $\eta r$ of the thus prepared solution relative to the solvent was measured at 30°C to thereby determine an intrinsic viscosity $[\eta]$ thereof.

(4) Water-resistant elongation of film:

Using a personal pressure cooker "PC-242HS-E" manufactured by Hirayama Manufacturing Corp., the film was treated in an atmosphere of 120°C and 100% RH for 35 hr. Next, after the film was conditioned with respect to temperature and humidity thereof in an atmosphere of 23°C and 50% RH for 24 hr, the elongation at break of the film in a film-forming direction (MD direction) as mechanical properties thereof was measured. The measurement of the elongation at break of the film was conducted using a universal tester "AUTOGRAPH" manufactured by Shimadzu Corp., under the conditions that the width of the sample was 15 mm; a distance between chucks was 50 mm; and an elastic stress rate was 200 mm/min. The retention rate (%) of the elongation at break between before and after the above treatment was calculated from the following formula (1), and the film was evaluated according to the following ratings.

$$\text{Retention rate of elongation at break = (elongation at}$$
$$\text{break after treatment)} \div \text{(elongation at break before}$$
$$\text{treatment)} \times 100 \qquad (1)$$

A: The retention rate was not less than 80%;
B: The retention rate was not less than 60% and less than 80%;
C: The retention rate was not less than 30% and less than 60%; and
D: The retention rate was less than 30%.

(5) Adhesion strength to EVA:

A polyester film was cut into two small pieces each having a length of 300 mm and a width of 25 mm such that the longitudinal direction of each small piece was aligned with the MD direction. On the other hand, an EVA film was cut into a small piece having a length of 50 mm and a width of 25 mm, and the small piece of the EVA film was interposed between the two small pieces of the polyester film such that a coating layer of each small piece of the polyester film faced to the small piece of the EVA film. The thus overlapped film pieces were laminated using a heat sealer device "TP-701" manufactured by Tester Sangyo Co., Ltd. The EVA film used in the above measurement was "485.00" (standard cured type; thickness: 0.5 mm) produced by Etimex GmbH, Germany, and the heat sealing procedure were conducted at a temperature of 150°C under a pressure of 0.13 MPa for 20 min. In order to measure an adhesion strength of the polyester film to EVA, the 25 mm-width small piece of the polyester/EVA laminated film was cut into a sample having a length of 300 mm and a width of 15 mm. The obtained sample was fitted to a tensile/bending tester "EZ Graph" manufactured by Shimadzu Corp., at end portions thereof where each polyester film small piece having a width of 15 mm was not laminated with the EVA film small piece. Successively, the polyester/EVA laminated film sample was separated into the respective film piece layers at a peel angle of 180° and a peel speed of 100 m/sec to measure a force (adhesion strength) required for separating the respective film piece layers of the polyester/EVA laminated film from each other. The measurement was conducted with respect to 10 samples, and the measurement results were classified into the following ratings on the basis of an average value of the measured adhesion strength values.

A: The adhesion strength was not less than 50 N/15 mm in width;
B: The adhesion strength was not less than 30 N/15 mm in width and less than 50 N/15 mm in width;
C: The adhesion strength was not less than 10 N/15 mm in width and less than 30 N/15 mm in width; and
D: The adhesion strength was less than 10 N/15 mm in width.

(6) Water-resistant adhesion strength to EVA:

The 25 mm-width test piece of the polyester/EVA laminated film prepared in the above (5) was subjected to wet heat treatment in an atmosphere of 120°C and 100% RH for 35 hr in the same manner as defined in the above (4). Next, the sample was conditioned with respect to temperature and humidity thereof in an atmosphere of 23°C and 50% RH for 24 hr, and then cut into a measuring sample piece having a width of 15 mm. The measuring sample piece was subjected to the same measurement as defined in the above (5) to determine an average value of the force (adhesion strength) required for separating the polyester/EVA laminated film into the respective film piece layers. From the thus measured adhesion strength and the adhesion strength before subjected to the wet heat treatment, the retention rate of the adhesion strength was calculated according to the following formula, and the adhesion strength of the film was evaluated by the following ratings.

```
Retention rate (%) of adhesion strength = (adhesion
strength after wet heat treatment)/(adhesion strength before
wet heat treatment)
```

A: The retention rate was not less than 70%;
B: The retention rate was not less than 50% and less than 70%;
C: The retention rate was less than 50%; and
D: The polyester film itself was considerably deteriorated, and suffered from breakage or damage.

(7) Adhesion property to polyvinyl butyral (PVB):

• Preparation of PVB sheet for evaluation

Six parts by weight of powdery PVB (molecular weight: about 110,000; butyralization degree: 65 mol%; hydroxyl group content: about 34 mol%) and 4 parts by weight of tri(ethylene glycol)-bis-2-ethyl hexanoate (as a plasticizer) were mixed and swelled with 45 parts by weight of toluene, and then 45 parts by weight of ethanol were added to the resulting mixture to dissolve PVB therein. The obtained PVB solution was filled in a Teflon (registered trademark) petri dish, and dried in a hot air oven at 100°C for 1 hr to thereby obtain a PVB sheet having a thickness of about 0.4 mm.

• Evaluation for adhesion property:

The thus obtained PVB sheet was cut into a sheet piece having a width of 1 cm and a length of 10 cm. The thus cut sheet piece was sandwiched between two films to be tested such that an easy-bonding surface of the respective films faced to the PVB sheet piece, and thermocompression-bonded together using a heat seal tester "TP-701" manufactured by Tester Sangyo Co., Ltd. The testing conditions used above were as follows.

Pressure: 0.13 MPa
Temperature: 140°C
Time: 3 min

The thus thermocompression-bonded laminated film was allowed to stand for cooling over day and night, and the thermocompression-bonded portions were peeled off by hands to evaluate an adhesion property thereof according to the following ratings.

A: Good adhesion strength (test films or PVB sheet were damaged upon peeling, or a strong peeling force was required for peeling them at a bonding boundary therebetween);
B: Normal adhesion strength (being peeled at the bonding boundary with a feel of a light resisting force);
C: Poor adhesion strength (readily being peeled at the bonding boundary with substantially no feel of a resisting force); and
D: The polyester film itself was considerably deteriorated, and suffered from breakage or damage upon peeling.

(8) Water-resistant adhesion property to PVB:

The test sample for evaluation of adhesion property prepared in the above (7) was subjected to wet heat treatment in an atmosphere of 85°C and 85% RH for 500 hr using a thermo-hygrostat "PR-2KP" manufactured by ESPEC Corp. The thus treated sample was taken out from the thermo-hygrostat and allowed to stand for cooling over day and night, and thereafter subjected to evaluation for an adhesion property thereof in the same manner as defined in the above (7).
Next, the polyester raw materials used in the following Examples and Comparative Examples are explained.

<Method for production of polyester (1)>

A reaction vessel was charged with 100 parts by weight of dimethyl terephthalate and 60 parts by weight of ethylene glycol as starting materials as well as 0.09 part by weight of magnesium acetate tetrahydrate as a catalyst, and the reaction temperature in the reaction vessel was gradually raised from 150°C as a reaction initiation temperature while distilling off methanol as produced until reaching 230°C after 3 hr. After the elapse of 4 hr, the transesterification reaction was substantially terminated. The resulting reaction mixture was mixed with 0.04 part by weight of antimony trioxide, and the resulting mixture was subjected to polycondensation reaction for 4 hr. That is, in the above polycondensation reaction, the reaction temperature was gradually raised from 230°C and finally allowed to reach 280°C. On the other hand, the reaction pressure was gradually dropped from normal pressures and finally allowed to reach 40 Pa. After initiation of the reaction, the change in agitation power in the reaction vessel was monitored, and the reaction was terminated at the time at which the agitation power reached the value corresponding to an intrinsic viscosity of 0.61. The resulting polymer was withdrawn from the reaction vessel under application of a nitrogen pressure. As a result, it was confirmed that the thus obtained polyester (1) had an intrinsic viscosity of 0.61, and the terminal carboxylic acid content of the polymer was 32 equivalents/t.

<Method for production of polyester (2)>

The polyester (1) as a starting material was subjected to solid state polymerization at 220°C in vacuo to thereby obtain a polyester (2). As a result, it was confirmed that the thus obtained polyester (2) had an intrinsic viscosity of 0.81, and the terminal carboxylic acid content of the polymer was 8 equivalents/t.

<Method for production of polyester (3)>

The same procedure as defined in the above method for production of the polyester (1) was conducted except that after completion of the transesterification reaction, 0.1 part by weight of silica particles having an average particle diameter of 2.6 $\mu$m in the form of a dispersion in ethylene glycol was added to the reaction solution, thereby obtain a polyester (3). As a result, it was confirmed that the thus obtained polyester (3) had an intrinsic viscosity of 0.61, and the terminal carboxylic acid content of the polymer was 28 equivalents/t.

<Method for production of polyester (4)>

The polyester (3) as a starting material was subjected to solid state polymerization at 220°C in vacuo to thereby obtain a polyester (4). As a result, it was confirmed that the thus obtained polyester (4) had an intrinsic viscosity of 0.73, and the terminal carboxylic acid content of the polymer was 10 equivalents/t.

<Method for production of polyester (5)>

The same procedure as defined in the above method for production of the polyester (1) was conducted except that after completion of the transesterification reaction, 0.047 part by weight of orthophosphoric acid (0.015 part by weight in terms of phosphorus element) was added to the reaction solution, and then 0.04 part by weight of antimony trioxide was added thereto, thereby obtain a polyester (5). As a result, it was confirmed that the thus obtained polyester (3) had an intrinsic viscosity of 0.61, and the terminal carboxylic acid content of the polymer was 29 equivalents/t.

<Method for production of polyester (6)>

The polyester (5) as a starting material was subjected to solid state polymerization at 220°C in vacuo to thereby obtain a polyester (6). As a result, it was confirmed that the thus obtained polyester (6) had an intrinsic viscosity of 0.73, and the terminal carboxylic acid content of the polymer was 10 equivalents/t.

<Method for production of white pigment master batch 1 (WMB1)>

The above polyester (2) was charged into a vented twin-screw extruder, and then barium sulfate particles (having a particle diameter of 0.8 $\mu$m) were fed into the extruder such that the content of barium sulfate particles in the resulting mixture was 50% by weight, and the mixture was formed into chips, thereby obtaining a white pigment master batch (WMB1).

<Method for production of white pigment master batch 2 (WMB2)>

The above polyester (2) was charged into a vented twin-screw extruder, and then titanium oxide of an anatase crystal type (having a particle diameter of 0.3 $\mu$m) was fed into the extruder such that the content of titanium oxide in the resulting mixture was 50% by weight, and the mixture was formed into chips, thereby obtaining a white pigment master batch (WMB2).

<Method for production of white pigment master batch 3 (WMB3)>

The above polyester (6) was charged into a vented twin-screw extruder, and then titanium oxide of an anatase crystal type (having a particle diameter of 0.3 $\mu$m) was fed into the extruder such that the content of titanium oxide in the resulting mixture was 50% by weight, and the mixture was formed into chips, thereby obtaining a white pigment master batch (WMB3).

<Coating agents and formulation of coating agents>

The formulation of the coating agents for the coating layer are shown in Table 2 below. Meanwhile, the amounts of the respective components added as shown in Table 2 all represent "% by weight" in terms of a solid content. The coating agents used were as follows.

- U-1: A water dispersion of a polyurethane produced from polytetramethylene glycol having a number-average molecular weight of about 1000, dimethylol propionic acid and isophorone diisocyanate (counter ion of carboxylic acid: ammonia)
- U-2: A water dispersion of a polyurethane produced from a polycarbonate polyol of hexamethylene diol (having a number-average molecular weight of about 1000), dimethylol propionic acid and hydrogenated diphenyl methane-4,4'-diisocyanate (counter ion of carboxylic acid: triethylamine)
- U-3: "HYDRAN (registered trademark) AP-40F" (tradename) produced by DIC Corp., as a water dispersion of a polyester polyurethane produced from an aromatic polyester and an aliphatic diisocyanate
- E-1: "FINTEX (registered trademark) ES-670" (tradename) produced by DIC Corp., as a water dispersion of an aromatic polyester
- X-1: "EPOCROSS (registered trademark) WS-500" (tradename) produced by Nippon Shokubai Co., Ltd., as an oxazoline-based water-soluble resin crosslinking agent
- X-2: "CARBODILITE (registered trademark) V-02-L2" (tradename) produced by Nisshinbo Chemical Inc., as a carbodiimide-based water-soluble resin crosslinking agent
- X-3: "DENACOL (registered trademark) EX-521" (tradename) produced by Nagase Chemtex Co., Ltd., as a water-soluble epoxy-based crosslinking agent
- D-1: A water dispersion of silica fine particles (average particle diameter: 60 nm)

Table 2

| Coating solutions | Polyurethane | | Other resins | |
|---|---|---|---|---|
| | Kind | Amount added (%) | Kind | Amount added (%) |
| Coating solution 1 | U-1 | 40 | - | - |
| Coating solution 2 | U-1 | 40 | - | - |
| Coating solution 3 | U-2 | 40 | - | - |
| Coating solution 4 | U-2 | 40 | - | - |
| Coating solution 5 | U-3 | 40 | - | - |
| Coating solution 6 | U-3 | 40 | - | - |
| Coating solution 7 | U-2 | 40 | - | - |
| Coating solution 8 | U-1 | 95 | - | - |
| Coating solution 9 | - | - | - | - |
| Coating solution 10 | - | - | E-1 | 40% |

Table 2 (continued)

| Coating solutions | Crosslinking agent | | Fine particles | |
|---|---|---|---|---|
| | Kind | Amount added (%) | Kind | Amount added (%) |
| Coating solution 1 | X-1 | 55 | D-1 | 5 |
| Coating solution 2 | X-2 | 55 | D-1 | 5 |
| Coating solution 3 | X-1 | 55 | D-1 | 5 |
| Coating solution 4 | X-2 | 55 | D-1 | 5 |
| Coating solution 5 | X-1 | 55 | D-1 | 5 |
| Coating solution 6 | X-2 | 55 | D-1 | 5 |
| Coating solution 7 | X-3 | 55 | D-1 | 5 |
| Coating solution 8 | - | - | D-1 | 5 |
| Coating solution 9 | X-2 | 95 | D-1 | 5 |
| Coating solution 10 | X-1 | 55 | D-1 | 5 |

Example 1:

The above polyester (2) and the above polyester (4) were mixed with each other at a mixing weight ratio of 70:30 to obtain a polyester mixture as a raw material for a polyester (A) layer, and further the polyester (2) and the white pigment master batch 1 (WMB1) were mixed with each other at a mixing weight ratio of 70:30 to obtain a polyester mixture as a raw material for a polyester (B) layer. The resulting raw materials were charged into two separate vented twin-screw extruders, respectively, melted and extruded at 290°C from the respective extruders, laminated through a multi-manifold die to form a molten sheet having a layer structure ratio of A/B = 2/3, and then allowed to adhere onto a casting drum whose surface temperature was maintained at 40°C to rapidly cool and solidify the sheet by an electrostatic adhesion method, thereby obtaining an unstretched sheet. The longest retention time of the above melting and extruding procedure was 12 min. The thus obtained sheet was stretched at 85°C at a stretch ratio of 3.6 times in a longitudinal direction thereof by a roll stretching method. At this time, a surface of the polyester (A) layer was subjected to corona discharge treatment, and then the coating agent 1 as shown in Table 2 above was applied onto the thus treated surface of the sheet using a bar coater such that the coating amount of the coating agent 1 was adjusted to 0.02 g/m$^2$ as measured on the finally obtained film. Next, the resulting coated sheet was introduced into a tenter, and dried therein at 100°C and then stretched at 110°C at a stretch ratio of 3.9 times in a lateral direction thereof. The thus biaxially stretched sheet was further subjected to heat treatment at 220°C and then contracted by 4% at 200°C in a width direction thereof, thereby obtaining a film having a thickness of 50 $\mu$m. The properties and evaluation results of the thus obtained film are shown in Table 3 below.

Example 2:

In the same manner as defined in Example 1, the above polyester (2) and the above polyester (4) were mixed with each other at a mixing weight ratio of 70:30 to obtain a polyester mixture as a raw material for a polyester (A) layer, and further the polyester (2) and the white pigment master batch 2 (WMB2) were mixed with each other at a mixing weight ratio of 70:30 to obtain a polyester mixture as a raw material for a polyester (B) layer. The resulting raw materials were charged into two separate vented twin-screw extruders, respectively, melted and extruded at 290°C from the respective extruders, laminated through a multi-manifold die to form a molten sheet having a layer structure ratio of A/B/A = 3/44/3, and then allowed to adhere onto a casting drum whose surface temperature was maintained at 40°C to rapidly cool and solidify the sheet by an electrostatic adhesion method, thereby obtaining an unstretched sheet. The longest retention time of the above melting and extruding procedure was 14 min. The thus obtained sheet was stretched at 85°C at a stretch ratio of 3.6 times in a longitudinal direction thereof by a roll stretching method. At this time, a surface of the polyester (A) layer was subjected to corona discharge treatment, and then the coating agent 1 as shown in Table 2 above was applied onto the thus treated surface of the sheet using a bar coater such that the coating amount of the coating agent 1 was adjusted to 0.02 g/m$^2$ as measured on the finally obtained film. Next, the resulting coated sheet was introduced into a tenter, and dried therein at 100°C and then stretched at 110°C at a stretch ratio of 3.9 times in a lateral direction thereof. The thus biaxially stretched sheet was further subjected to heat treatment at 220°C and then contracted by 4% at 200°C in a width direction thereof, thereby obtaining a film having a thickness of 50 $\mu$m. The properties and evaluation results of the thus obtained film are shown in Table 3 below.

Example 3:

The same procedure as defined in Example 2 was conducted except that the raw material for a polyester (A) layer was replaced with a polyester mixture prepared by mixing the polyester (2), the polyester (4) and the white pigment master batch 2 (WMB2) with each other at a mixing weight ratio of 56:30:14, thereby obtaining a film having a thickness of 50 $\mu$m. The longest retention time of the above melting and extruding procedure was 14 min. The properties and evaluation results of the thus obtained film are shown in Table 3 below.

Example 4:

The same procedure as defined in Example 2 was conducted except that the raw material for a polyester (A) layer was replaced with a polyester mixture prepared by mixing the polyester (2), the polyester (4) and the white pigment master batch 2 (WMB2) with each other at a mixing weight ratio of 60:30:10 and further the raw material for a polyester (B) layer was replaced with a polyester mixture prepared by mixing the polyester (2) and the white pigment master batch 2 (WMB2) with each other at a mixing weight ratio of 70:30, thereby obtaining a film having a thickness of 50 $\mu$m. The longest retention time of the above melting and extruding procedure was 14 min. The properties and evaluation results of the thus obtained film are shown in Table 3 below.

Example 5:

The same procedure as defined in Example 2 was conducted except that the raw material for a polyester (A) layer was replaced with a polyester mixture prepared by mixing the polyester (6) and the polyester (4) with each other at a mixing weight ratio of 70:30 and further the raw material for a polyester (B) layer was replaced with a polyester mixture prepared by mixing the polyester (2) and the white pigment master batch 3 (WMB3) with each other at a mixing weight ratio of 50:50, and the layer structure ratio of the polyester (A) layer and the polyester (B) layer in the film was changed to A/B/A = 15/20/15, thereby obtaining a film having a thickness of 50 $\mu$m. The longest retention time of the above melting and extruding procedure was 14 min. The properties and evaluation results of the thus obtained film are shown in Table 3 below.

Comparative Example 1:

The same procedure as defined in Example 2 was conducted except that the surface to be subjected to corona discharge treatment and coated with the coating solution 1 was changed to the surface of the polyester (B) layer, thereby obtaining a film having a thickness of 50 $\mu$m. The longest retention time of the above melting and extruding procedure was 12 min. The properties and evaluation results of the thus obtained film are shown in Table 4 below.

Comparative Example 2:

The same procedure as defined in Example 2 was conducted except that the raw material for a polyester (A) layer was replaced with a polyester mixture prepared by mixing the polyester (2) and the white pigment master batch 2 (WMB2) with each other at a mixing weight ratio of 70:30 and further the raw material for a polyester (B) layer was replaced with a polyester mixture prepared by mixing the polyester (2) and the white pigment master batch 2 (WMB2) with each other at a mixing weight ratio of 86:14, thereby obtaining a film having a thickness of 50 $\mu$m. The longest retention time of the above melting and extruding procedure was 14 min. The properties and evaluation results of the thus obtained film are shown in Table 4 below.

Comparative Example 3:

The same procedure as defined in Example 2 was conducted except that the raw material for a polyester (A) layer was replaced with a polyester mixture prepared by mixing the polyester (2), the polyester (4) and the white pigment master batch 2 (WMB2) with each other at a mixing weight ratio of 50:30:20, thereby obtaining a film having a thickness of 50 $\mu$m. The longest retention time of the above melting and extruding procedure was 14 min. The properties and evaluation results of the thus obtained film are shown in Table 4 below.

Comparative Example 4:

The same polyester raw materials as used in Example 3 were melted and extruded to obtain an unstretched film having a layer structure ratio of A/B/A = 3/44/3. At this time, the extrusion output was reduced such that the longest retension time of the melting and extruding procedure was 23 min. The subsequent procedure was conducted in the same manner as in Example 3, thereby obtaining a film having a thickness of 50 $\mu$m. The properties and evaluation results of the thus obtained film are shown in Table 4 below.

Examples 6 to 9 and Comparative Examples 5 to 9:

The same procedure as defined in Example 3 was conducted except that the coating agent used in the coating layer was replaced with the coating agents 2 to 10 as shown in Table 2, thereby obtaining films. The properties and evaluation results of the thus obtained films are shown in Tables 5 and 6 below. Meanwhile, the term "Co" appearing in "Laminated layer structure of film" in Tables 3 to 6 means a coating layer.

Table 3

| | Examples | | | | |
| --- | --- | --- | --- | --- | --- |
| | 1 | 2 | 3 | 4 | 5 |
| Laminated layer structure of film | Co/A/B | Co/A/B /A | Co/A/B /A | Co/A/B /A | Co/A/B /A |
| (A) layer: | | | | | |
|    Kind of particles | silica | silica | silica | silica | silica |
|    Amount of particles   (wt%) | 0.03 | 0.03 | 0.03 | 0.03 | 0.03 |
|    Kind of particles | - | - | $TiO_2$ | $TiO_2$ | - |
|    Amount of particles   (wt%) | | | 7 | 5 | |
|    Thickness of layer   ($\mu$m) | 20 | 3 | 3 | 3 | 15 |
| (B) layer | | | | | |
|    Kind of particles | $BaSO_4$ | $TiO_2$ | $TiO_2$ | $TiO_2$ | $TiO_2$ |
|    Amount of particles   (wt%) | 15 | 15 | 15 | 15 | 25 |
|    Thickness of layer   ($\mu$m) | 30 | 44 | 44 | 44 | 20 |
| Kind of coating layer[*1) | 1 | 1 | 1 | 1 | 1 |
| Terminal carboxylic acid content (equivalent/t) | 21 | 22 | 26 | 25 | 23 |
| Phosphorus element amount (ppm) | 0 | 0 | 0 | 0 | 92 |
| Elongation at break of film (hydrolysis resistance) | A | A | B | B | B |
| Adhesion strength to EVA | A | A | A | A | A |
| Adhesion strength to EVA (hydrolysis resistance) | A | A | B | B | B |
| Adhesion property to PVB | A | A | A | A | A |
| Adhesion property to PVB (hydrolysis resistance) | A | A | A | A | A |
| Note: *1): Coating agent (solution) No. | | | | | |

Table 4

| | Comparative Examples | | | |
|---|---|---|---|---|
| | 1 | 2 | 3 | 4 |
| Laminated layer structure of film | A/B/Co | Co/A/B/A | Co/A/B/A | Co/A/B/A |
| (A) layer: | | | | |
| Kind of particles | silica | - | silica | silica |
| Amount of particles (wt%) | 0.03 | - | 0.03 | 0.03 |
| Kind of particles | - | $TiO_2$ | $TiO_2$ | $TiO_2$ |
| Amount of particles (wt%) | - | 15 | 10 | 7 |
| Thickness of layer ($\mu$m) | 20 | 3 | 3 | 3 |
| B) layer | | | | |
| Kind of particles | $BaSO_4$ | $TiO_2$ | $TiO_2$ | $TiO_2$ |
| Amount of particles (wt%) | 15 | 7 | 15 | 15 |
| Thickness of layer ($\mu$m) | 30 | 44 | 44 | 44 |
| Kind of coating layer[*1] | 1 | 1 | 1 | 1 |
| Terminal carboxylic acid content (equivalent/t) | 21 | 24 | 25 | 31 |
| Phosphorus element amount (ppm) | 0 | 0 | 0 | 0 |
| Elongation at break of film (hydrolysis resistance) | A | B | B | C |
| Adhesion strength to EVA | A | A | A | A |
| Adhesion strength to EVA (hydrolysis resistance) | C | C | C | C |
| Adhesion property to PVB | A | A | A | A |
| Adhesion property to PVB (hydrolysis resistance) | D | D | D | D |
| Note: *1): Coating agent (solution) No. | | | | |

Table 5

| | Examples | | | |
|---|---|---|---|---|
| | 6 | 7 | 8 | 9 |
| Laminated layer structure of film | Co/A/B/A | Co/A/B/A | Co/A/B/A | Co/A/B/A |
| (A) layer: | | | | |
| Kind of particles | silica | silica | silica | silica |
| Amount of particles (wt%) | 0.03 | 0.03 | 0.03 | 0.03 |
| Kind of particles | $TiO_2$ | $TiO_2$ | $TiO_2$ | $TiO_2$ |
| Amount of particles (wt%) | 7 | 7 | 7 | 7 |
| Thickness of layer ($\mu$m) | 3 | 3 | 3 | 3 |
| (B) layer | | | | |
| Kind of particles | $TiO_2$ | $TiO_2$ | $TiO_2$ | $TiO_2$ |
| Amount of particles (wt%) | 15 | 15 | 15 | 15 |
| Thickness of layer ($\mu$m) | 44 | 44 | 44 | 44 |
| Kind of coating layer[*1] | 2 | 3 | 4 | 7 |

(continued)

| | Examples | | | |
|---|---|---|---|---|
| | 6 | 7 | 8 | 9 |
| Terminal carboxylic acid content (equivalent/t) | 0 | 0 | 0 | 0 |
| Phosphorus element amount (ppm) | 22 | 22 | 22 | 22 |
| Elongation at break of film (hydrolysis resistance) | A | A | A | A |
| Adhesion strength to EVA | A | A | A | B |
| Adhesion strength to EVA (hydrolysis resistance) | A | A | A | B |
| Adhesion property to PVB | A | A | A | A |
| Adhesion property to PVB (hydrolysis resistance) | A | A | A | A |
| Note: *1): Coating agent (solution) No. | | | | |

Table 6

| | Comparative Examples | | | | |
|---|---|---|---|---|---|
| | 5 | 6 | 7 | 8 | 9 |
| Laminated layer structure of film | Co/A/B /A | Co/A/B /A | Co/A/B /A | Co/A/B /A | Co/A/B /A |
| (A) layer: | | | | | |
|   Kind of particles | silica | silica | silica | silica | silica |
|   Amount of particles (wt%) | 0.03 | 0.03 | 0.03 | 0.03 | 0.03 |
|   Kind of particles | $TiO_2$ | $TiO_2$ | $TiO_2$ | $TiO_2$ | $TiO_2$ |
|   Amount of particles (wt%) | 7 | 7 | 7 | 7 | 7 |
|   Thickness of layer ($\mu$m) | 3 | 3 | 3 | 3 | 3 |
| (B) layer | | | | | |
|   Kind of particles | $TiO_2$ | $TiO_2$ | $TiO_2$ | $TiO_2$ | $TiO_2$ |
|   Amount of particles (wt%) | 15 | 15 | 15 | 15 | 15 |
|   Thickness of layer ($\mu$m) | 44 | 44 | 44 | 44 | 44 |
| Kind of coating layer[*1) | 5 | 6 | 8 | 9 | 10 |
| Terminal carboxylic acid content (equivalent/t) | 0 | 0 | 0 | 0 | 0 |
| Phosphorus element amount (ppm) | 22 | 22 | 22 | 22 | 22 |
| Elongation at break of film (hydrolysis resistance) | A | A | A | A | A |
| Adhesion strength to EVA | B | B | B | D | B |
| Adhesion strength to EVA (hydrolysis resistance) | C | C | C | *2) | C |
| Adhesion property to PVB | A | A | A | C | A |
| Adhesion property to PVB (hydrolysis resistance) | C | C | C | C | C |
| Note: *1): Coating agent (solution) No.; *2): Not evaluated | | | | | |

INDUSTRIAL APPLICABILITY

The film of the present invention can be suitably used, for example, as a film for a protective material for protecting a back surface of photovoltaic cells.

**Claims**

1. A biaxially stretched polyester film for a protective material for protecting a back surface of photovoltaic cells comprising:

   - a laminated polyester film produced by co-extrusion, wherein the laminated polyester film comprises the below-mentioned polyester (A) layer as at least one of outermost layers of the laminated polyester film and at least one below-mentioned polyester (B) layer, wherein the laminated polyester film has a terminal carboxyl group content of not more than 26 equivalents/t:

     • Polyester (A) layer: Layer formed of a polyester comprising an aromatic polyester as a main constitutional component and having a white pigment content of less than 8% by weight; and
     • Polyester (B) layer: Layer formed of a polyester comprising an aromatic polyester as a main constitutional component and having a white pigment content of not less than 8% by weight;

   - a coating layer which is provided on at least one of the at least one outermost polyester (A) layer and is formed of a polyurethane having at least one of a polycarbonate skeleton and a polyether skeleton, and a crosslinking agent;
   - a sealing resin for a photovoltaic cell adhered onto the coating layer.

2. A biaxially stretched polyester film for a protective material for protecting a back surface of photovoltaic cells according to claim 1, wherein a weight ratio of the crosslinking agent to the polyurethane (crosslinking agent/polyurethane) is 10/90 to 90/10.

3. A biaxially stretched polyester film for a protective material for protecting a back surface of photovoltaic cells according to claim 1, wherein the crosslinking agent is at least one polymer selected from the group consisting of an oxazoline-based polymer and a carbodiimide-based polymer.

4. A biaxially stretched polyester film for a protective material for protecting a back surface of photovoltaic cells according to any one of claims 1 to 3, wherein an ethylene-vinyl acetate copolymer resin layer is laminated on at least one of the coating layers.

5. A biaxially stretched polyester film for a protective material for protecting a back surface of photovoltaic cells according to any one of claims 1 to 3, wherein a polyvinyl butyral resin layer is laminated on at least one of the coating layers.

6. A biaxially stretched polyester film for a protective material for protecting a back surface of photovoltaic cells according to any one of claims 1 to 5, wherein the sealing resin for a photovoltaic cell is selected from the group consisting of EVA, PBV, ethylene-methyl acrylate copolymers (EMA), ethylene-ethyl acrylate copolymers (EEA) and ethylene-$\alpha$-olefin copolymers.

7. Use of a biaxially stretched polyester film as a protective material for protecting a back surface of photovoltaic cells, wherein the polyester film comprises:

   - a laminated polyester film produced by co-extrusion, wherein the laminated polyester film comprises the below-mentioned polyester (A) layer as at least one of outermost layers of the laminated polyester film and at least one below-mentioned polyester (B) layer, wherein the laminated polyester film has a terminal carboxyl group content of not more than 26 equivalents/t:

     • Polyester (A) layer: Layer formed of a polyester comprising an aromatic polyester as a main constitutional component and having a white pigment content of less than 8% by weight; and
     • Polyester (B) layer: Layer formed of a polyester comprising an aromatic polyester as a main constitutional component and having a white pigment content of not less than 8% by weight;

   - a coating layer which is provided on at least one of the at least one outermost polyester (A) layer and is formed of a polyurethane having at least one of a polycarbonate skeleton and a polyether skeleton, and a crosslinking agent;
   - a sealing resin for a photovoltaic cell adhered onto the coating layer.

**EP 2 565 936 B1**

**Patentansprüche**

1. Biaxial gereckte Polyesterfolie für ein Schutzmaterial zum Schützen einer Rückseite von Photovoltaikzellen, umfassend:

   - eine laminierte Polyesterfolie, hergestellt durch Co-Extrusion, wobei die laminierte Polyesterfolie die nachfolgend genannte Polyester (A)-Schicht als mindestens eine von äußersten Schichten der laminierten Polyesterfolie und mindestens eine nachfolgend genannte Polyester (B)-Schicht umfasst, wobei die laminierte Polyesterfolie einen terminalen Carboxylgruppengehalt von nicht mehr als 26 Äquivalente/t aufweist:

   • Polyester (A)-Schicht: Schicht, gebildet aus einem Polyester, umfassend einen aromatischen Polyester als eine Hauptaufbaukomponente und mit einem Weißpigmentgehalt von weniger als 8 Gew.-%; und
   • Polyester (B)-Schicht: Schicht, gebildet aus einem Polyester, umfassend einen aromatischen Polyester als eine Hauptaufbaukomponente und mit einem Weißpigmentgehalt von nicht weniger als 8 Gew.-%;

   - eine Überzugsschicht, die auf mindestens einer der mindestens einen äußersten Polyester (A)-Schicht vorgesehen ist und gebildet ist aus einem Polyurethan, das mindestens eines aus einem Polycarbonatgerüst und einem Polyethergerüst aufweist, und einem Vernetzungsmittel;
   - ein Versiegelungsharz für eine Photovoltaikzelle, das auf der Überzugsschicht anhaftet.

2. Biaxial gereckte Polyesterfolie für ein Schutzmaterial zum Schützen einer Rückseite von Photovoltaikzellen nach Anspruch 1, wobei ein Gewichtsverhältnis des Vernetzungsmittels zu dem Polyurethan (Vernetzungsmittel/Polyurethan) 10/90 bis 90/10 beträgt.

3. Biaxial gereckte Polyesterfolie für ein Schutzmaterial zum Schützen einer Rückseite von Photovoltaikzellen nach Anspruch 1, wobei das Vernetzungsmittel mindestens ein Polymer ist, gewählt aus der Gruppe, bestehend aus einem Oxazolin-basierten Polymer und einem Carbodiimid-basierten Polymer.

4. Biaxial gereckte Polyesterfolie für ein Schutzmaterial zum Schützen einer Rückseite von Photovoltaikzellen nach mindestens einem der Ansprüche 1 bis 3, wobei eine Ethylen-Vinylacetat-Copolymer-Harzschicht auf mindestens eine der Überzugsschichten laminiert ist.

5. Biaxial gereckte Polyesterfolie für ein Schutzmaterial zum Schützen einer Rückseite von Photovoltaikzellen nach mindestens einem der Ansprüche 1 bis 3, wobei eine Polyvinylbutyralharzschicht auf mindestens eine der Überzugsschichten laminiert ist.

6. Biaxial gereckte Polyesterfolie für ein Schutzmaterial zum Schützen einer Rückseite von Photovoltaikzellen nach mindestens einem der Ansprüche 1 bis 5, wobei das Versiegelungsharz für eine Photovoltaikzelle aus der Gruppe gewählt ist, bestehend aus EVA, PBV, Ethylen-Methylacrylat-Copolymeren (EMA), Ethylen-Ethylacrylat-Copolymeren (EEA) und Ethylen-$\alpha$-Olefin-Copolymeren.

7. Verwendung einer biaxial gereckten Polyesterfolie als ein Schutzmaterial zum Schützen einer Rückseite von Photovoltaikzellen, wobei die Polyesterfolie umfasst:

   - eine laminierte Polyesterfolie, hergestellt durch Co-Extrusion, wobei die laminierte Polyesterfolie die nachfolgend genannte Polyester (A)-Schicht als mindestens eine von äußersten Schichten der laminierten Polyesterfolie und mindestens eine nachfolgend genannte Polyester (B)-Schicht umfasst, wobei die laminierte Polyesterfolie einen terminalen Carboxylgruppengehalt von nicht mehr als 26 Äquivalente/t aufweist:

   • Polyester (A)-Schicht: Schicht, gebildet aus einem Polyester, umfassend einen aromatischen Polyester als eine Hauptaufbaukomponente und mit einem Weißpigmentgehalt von weniger als 8 Gew.-%; und
   • Polyester (B)-Schicht: Schicht, gebildet aus einem Polyester, umfassend einen aromatischen Polyester als eine Hauptaufbaukomponente und mit einem Weißpigmentgehalt von nicht weniger als 8 Gew.-%;

   - eine Überzugsschicht, die auf mindestens einer der mindestens einen äußersten Polyester (A)-Schicht vorgesehen ist und gebildet ist aus einem Polyurethan, das mindestens eines aus einem Polycarbonatgerüst und einem Polyethergerüst aufweist, und einem Vernetzungsmittel;
   - ein Versiegelungsharz für eine Photovoltaikzelle, das auf der Überzugsschicht anhaftet.

22

**Revendications**

1. Film de polyester biaxialement étiré pour un matériau de protection pour protéger une surface arrière de cellules photovoltaïques, comprenant :

   - un film de polyester stratifié produit par co-extrusion, dans lequel le film de polyester stratifié comprend la couche de polyester (A) mentionnée ci-dessous en tant qu'au moins une des couches les plus externes du film de polyester stratifié et au moins une couche de polyester (B) mentionnée ci-dessous, dans lequel le film de polyester stratifié a une teneur en groupes carboxyle terminal de pas plus de 26 équivalents/t :

     ■ couche de polyester (A): couche formée d'un polyester comprenant un polyester aromatique en tant que principal composant constitutionnel et ayant une teneur en pigment blanc inférieure à 8% en poids; et
     ■ couche de polyester (B): couche formée d'un polyester comprenant un polyester aromatique en tant que principal composant constitutionnel et ayant une teneur en pigment blanc non inférieure à 8% en poids ;

   - une couche de revêtement qui est prévue sur au moins une de l'au moins une couche de polyester (A) et qui est formée d'un polyuréthane ayant au moins l'un d'un squelette de polycarbonate et d'un squelette de polyéther, et un agent de réticulation ;
   - une résine rendant étanche pour une cellule photovoltaïque adhérée sur la couche de revêtement.

2. Film de polyester biaxialement étiré pour un matériau de protection pour protéger une surface arrière de cellules photovoltaïques selon la revendication 1, dans lequel un rapport pondéral de l'agent de réticulation au polyuréthanne (agent de réticulation / polyuréthane) est 10/90 à 90/10.

3. Film de polyester biaxialement étiré pour un matériau de protection pour protéger une surface arrière de cellules photovoltaïques selon la revendication 1, dans lequel l'agent de réticulation est au moins un polymère choisi parmi le groupe constitué d'un polymère à base d'oxazoline et d'un polymère à base de carbodiimide.

4. Film de polyester biaxialement étiré pour un matériau de protection pour protéger une surface arrière de cellules photovoltaïques selon l'une quelconque des revendications 1 à 3, dans lequel couche de résine de copolymère d'acétate d'éthylènevinyle est stratifiée sur au moins une des couches de revêtement.

5. Film de polyester biaxialement étiré pour un matériau de protection pour protéger une surface arrière de cellules photovoltaïques selon l'une quelconque des revendications 1 à 3, dans lequel une couche de résine de polyvinylbutyral est stratifiée sur au moins une des couches de revêtement.

6. Film de polyester biaxialement étiré pour un matériau de protection pour protéger une surface arrière de cellules photovoltaïques selon l'une quelconque des revendications 1 à 5, dans lequel la résine rendant étanche pour une cellule photovoltaïque est choisi parmi le groupe constitué par EVA, PBV, les copolymères d'acrylate d'éthylène-méthyle (EMA), les les copolymères d'acrylate d'éthylène-éthyle (EEA), et les copolymères d'éthylène-$\alpha$-oléfine.

7. Utilisation d'un film de polyester biaxialement étiré en tant que matériau de protection pour protéger une surface arrière de cellules photovoltaïques, dans laquelle le film de polyester comprend:

   - un film de polyester stratifié produit par co-extrusion, dans lequel le film de polyester stratifié comprend la couche de polyester (A) mentionnée ci-dessous en tant qu'au moins une des couches les plus externes du film de polyester stratifié et au moins une couche de polyester (B) mentionnée ci-dessous, dans lequel le film de polyester stratifié a une teneur en groupes carboxyle terminal de pas plus de 26 équivalents/t :

     ■ couche de polyester (A): couche formée d'un polyester comprenant un polyester aromatique en tant que principal composant constitutionnel et ayant une teneur en pigment blanc inférieure à 8% en poids; et
     ■ couche de polyester (B): couche formée d'un polyester comprenant un polyester aromatique en tant que principal composant constitutionnel et ayant une teneur en pigment blanc non inférieure à 8% en poids ;

   - une couche de revêtement qui est prévue sur au moins une de l'au moins une couche de polyester (A) et qui est formée d'un polyuréthane ayant au moins l'un d'un squelette de polycarbonate et d'un squelette de polyéther, et un agent de réticulation ;
   - une résine rendant étanche pour une cellule photovoltaïque adhérée sur la couche de revêtement.

**EP 2 565 936 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006152013 A
- JP 2007204538 A
- JP 59005216 A
- JP 59217755 A